(19) Europäisches Patentamt
European Patent Office
Office européen des brevets

(11) Publication number: **0 062 733**
**B1**

# (12) EUROPEAN PATENT SPECIFICATION

(45) Date of publication of patent specification: **02.01.86**

(51) Int. Cl.$^4$: **G 03 F 7/26**

(21) Application number: **82100579.0**

(22) Date of filing: **28.01.82**

## (54) Metal ion-free photoresist developer composition.

(30) Priority: **10.04.81 US 252915**

(43) Date of publication of application:
**20.10.82 Bulletin 82/42**

(45) Publication of the grant of the patent:
**02.01.86 Bulletin 86/01**

(84) Designated Contracting States:
**BE DE FR GB IT NL SE**

(56) References cited:
**EP-A-0 023 758**

**RESEARCH DISCLOSURE, no. 186, October 1979, pages 575-576, no. 18620, Homewell Havant Hampshire (GB); J.R. GUILD: "Development of light-sensitive quinone diazide compositions"**

**IBM TECHNICAL DISCLOSURE BULLETIN, vol. 13, no. 7, December 1970, page 2009, New York (USA); M.J. GRIECO et al.: "Photoresist developer compounds".**

(73) Proprietor: **SHIPLEY COMPANY INC.**
**2300 Washington Street**
**Newton, Massachusetts 02162 (US)**

(72) Inventor: **Cawston, John D.**
**3 Indian Hill Road**
**Winchester, Massachusetts 01890 (US)**
Inventor: **Becker, Paul E. Jr.**
**22 Revere Street**
**Canton, Massachusetts 02021 (US)**

(74) Representative: **Bunke, Holger, Dr. et al**
**Patentanwälte Prinz, Bunke & Partner**
**Ernsbergerstrasse 19**
**D-8000 München 60 (DE)**

**EP 0 062 733 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**Description**

This invention relates to novel aqueous alkaline developer compositions for photosensitive resists and the use thereof. More specifically, it relates to high speed developer compositions which are metal ion-free.

In the manufacture of integrated circuit devices, printed circuit boards, printing plates, and in related arts, resist processes are used whereby photomechanical images are formed on a substrate to protect selected portions of the substrate during subsequent manufacturing processes such as, for example, etching, metal deposition, and diffusion processes. The resist processes employ radiation sensitive organic compositions which are coated onto the substrate surface and then exposed patternwise to light or other suitable actinic radiation such as, for example, x-rays, gamma rays, or an electron beam. The exposed resist layer is then developed by methods known in the art and the portions of the substrate which are bared by development can then be treated.

Both positive and negative working photoresists are known. A positive resist is composed typically of a base-soluble binder such as phenol-formaldehyde novolak resin and a sensitizer, that is, a photoactive compound, such as a diazo compound.

Such sensitizers and resists are described, for example, in U.S. Patent Numbers 3,046,118; 3,046,121; 3,106,465; 3,201,239; 3,666,473; 4,009,033 and 4,093,461. Other resists include, for example, acrylic resists and polyimide resists.

In manufacturing processes employing photoresists, the rate of production is dependent upon the time required to form the photomechanical image which, in turn, depends in part on the time required to expose the resist to the necessary amount of activating radiation and on the time required to then develop the latent image-bearing resist. Accordingly, four interrelated factors determine the rate of product through-put: radiation intensity and exposure time, and developing solution concentration and solution contact time.

Typically, exposed resists will dissolve in developer solution of a given concentration at a certain rate. This is true whether development is by immersion or by puddle or spray techniques. Generally, solution contact time is pre-set. The minimum necessary exposure time to achieve complete development of the photoresist is then determined, often by trial and error. Underexposure of the photoresist generally cannot be effectively off-set by using developing solution above the recommended concentration since this normally will result in significant loss of selectivity. That is, a greater portion of unexposed resist will be dissolved along with the exposed portion. Consequently, there is a disadvantageous loss of resolution in the photomechanical image and, therefore in the quality of the subsequently treated substrate. Accordingly, in a typical manufacturing process employing a source of actinic radiation of certain intensity, the proper exposure time is determined by first setting the time longer than necessary and decreasing it incrementally until the photomechanical image is just developed during the pre-set solution contact time. Thus, for example, where development is by immersion for 60 seconds in a developing solution, the exposure time is adjusted downward until development is just completed in the 60 second immersion time.

A significant disadvantage inherent in the use of known developers relates to metal ion contamination of the work piece, especially integrated circuit devices and the like. The ever smaller lines and spaces being used for circuitry of such devices make it necessary that there be no contamination by current carrying metal ions, since the functional properties of the device could be affected.

Known developers comprise metal ions and thus can cause metal ion contamination. Inadequate rinsing of the device after development of the photomechanical image can result in metal ion contamination and this is especially troublesome with automatic in-line developing methods, in which there is no immersion rinse. Metal ion contamination can cause failure of finished IC devices.

EP—A—0 023 758 discloses an aqueous metal ion-free developer composition containing

(A) a developing agent of the formula:

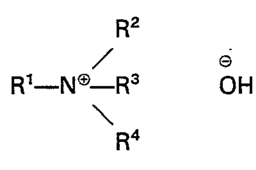

wherein $R^1$ is hydroxyalkyl, and each of $R^2$, $R^3$ and $R^4$ is hydrocarbyl or hydroxyalkyl; and

(B) anions selected from $SO_3^{=}$, $HSO_3^{\ominus}$ and $S_2O_5^{=}$, in an amount of from 0.01 to 0.4 moles per mole of said developing agent.

The additional incorporation of a sulfite, bisulfite or disulfite into the aqueous developer composition results in a stabilization of the developer composition which generally suffers from gradual decomposition of the quaternary alkanol ammonium hydroxide compound. The adverse effects resulting from the decomposition of the developing agents known per se are said to be prevented, or at least substantially reduced, by incorporating the above-mentioned sulphur compounds, thus leading to improved shelf-life characteristics of the stabilized compositions.

Although the addition of sulphur compounds might be useful in stabilizing the developer

compositions, there is the disadvantage that the sulfites used can cause sulfite ion contamination and reductive decomposition of the photoresist layers to be treated.

It is an object of this invention to provide an improved developer composition as well as an improved method of developing a photoresist avoiding thereby metal ion or sulfite contamination of the photoresist layer to be treated.

According to the present invention, the foregoing objects are achieved by the novel metal ion-free developer composition according to any one of claims 1 to 12.

According to a method aspect of the invention, there is provided a method of developing a photoresist by contacting it with the claimed aqueous metal ion-free developer composition.

The developer composition of the invention provides a significant advance in the art in that the exposure energy required to form the photomechanical resist image is reduced by as much as 40 to 50%. Yet, image quality and resolution are substantially improved over that obtained by the use of known developers.

The present invention provides a novel aqueous alkaline developer for photoresists. It operates preferably at a temperature of approximately 10° to 30°C, more preferably at about 20°C or room temperature.

The developer composition of the invention can be used in any manner suitable for known developers. Thus, immersion, spray, and puddle techniques can be used. The photoresist to be developed is generally applied to a substrate, image-wise exposed to actinic radiation and subsequently contacted with the developer. Development of the photomechanical image typically requires about 60 seconds if by immersion, less if by spray or puddle techniques. Subsequent to development, the work piece can then be rinsed and further processed as desired.

Metal ion-free alkali suitable for use in the novel developer composition of the invention are usually, but not necessarily, water soluble and must provide the necessary alkalinity. The novel developer composition of the invention operates preferably at a pH of from about 11 to 12.7, most preferably about 12.5. While the developer will function at a pH above 12.7, there can be significant attack on the unexposed portions of the resist with consequent decline in the resolution quality of the photomechanical image. Below about pH 11 there is significant decrease in the speed of development.

Suitable sources of alkali include, for example, aryl and alkyl amines including primary, secondary and tertiary substituted amines, wherein the substituents can be straight, branched or cyclic. Suitable amines include, for example, alkylene diamines such as, for example, 1,3-diamino propane, and aryl amines, for example, 4,4-diamino diphenylamine. Also suitable are imines, for example, BIS-(dialkylamino)imine. Preferably, alkyl substituents comprise from 1 to 12 carbon atoms. Preferred aryl substituents include phenyl and phenalkyl. Also suitable as a source of alkali is heterocyclic base, such as, for example, those comprising a ring having 3 to 5 carbon atoms with 1 or 2 heteroatoms selected from N, O, and S, for example, pyrrole, pyrollidine, pyrollidone, pyridine, morpholine, pyrazine, piperidine, oxazole and thiazole. Another suitable source of alkali is the quaternary ammonium bases such as, for example, the lower alkyl quaternary ammonium hydroxides and the like. Preferred alkali include tetraalkylammonium hydroxides, therein each alkyl substituent is the same or different and has from 1 to 3 carbons. Tetramethylammonium hydroxide is most preferred.

The metal ion-free surfactant of the developer composition of the invention comprises one or, preferably, a mixture of quaternary ammonium compounds having the general formula:

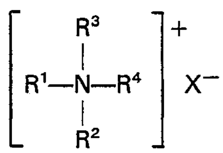 (I)

wherein

$R^1$ comprises a saturated or unsaturated, straight or branched hydrocarbon chain having from 6 to 20 carbons, and from zero to 3 oxygens, provided that each oxygen can be separated from others by at least one carbon, and which is alkoxy-substituted or unsubstituted;

$R^2$ and $R^3$ are the same or different and each comprises alkyl of from 1 to 3 carbons; or $(R^5O)_nH$ wherein $R^5$ is alkylene of 1 to 3 carbons and n is an integer from 1 to 20; or $R^2$ and $R^3$ together comprise a cycloaliphatic hydrocarbon of from 2 to 8 carbons with from zero to 2 heteroatom selected from O, N, and S, provided that each heteroatom be separated from another and from the quaternary nitrogen by at least one carbon; or $R^2$ and $R^3$ together comprise a cycloaromatic hydrocarbon of from 2 to 8 carbons with from zero to two nitrogen heteroatoms, provided that each nitrogen atom be separated from another and from the quaternary nitrogen by at least one carbon;

$R^4$ comprises a saturated or unsaturated, straight or branched hydrocarbon having from 1 to 10 carbon atoms, $(R^5O)_nH$ as defined above, phenalkyl, wherein the alkyl moiety has from 0 to 3 carbons, or

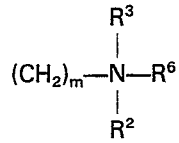

wherein

m is from 1 to 4;

$R^2$ and $R^3$ are as defined above, and

$R^6$ is saturated or unsaturated, straight or branched hydrocarbon having from 1 to 10 carbon atoms or $(R^5O)_nH$ as defined above, or phenol alkyl having an alkyl group of from 0 to 3 carbon atoms; and

X comprises halogen, hydroxy, or silicate, or the corresponding amino oxide of said quaternary ammonium compounds.

Preferably, there are in $R^2$, $R^3$, and $R^4$, in total, no more than 15 alkoxy units, $(R^5O)$, most preferably, no more than 2.

Preferred for use in the invention are quaternary ammonium compounds having the general formula II:

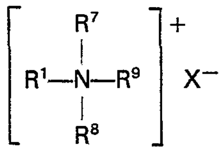

wherein

$R^1$ and X are defined for formula I;

$R^7$ and $R^8$ are the same or different and each comprises alkyl of from 1 to 3 carbons, or $(R^5O)_nH$ wherein n is 1 and $R^5$ is as defined for formula I; and

$R^9$ comprises a saturated or unsaturated, straight, branched or cyclic hydrocarbon having from 1 to 10 carbons, $(R^5O)_nH$ wherein n is 1 and $R^5$ is defined for formula I, phenalkyl wherein the alkyl moiety has from 0 to 3 carbons, or

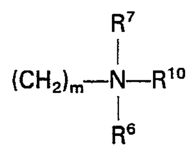

(III)

wherein

m is from 1 to 4, $R^6$ and $R^7$ are as defined above, and

$R^{10}$ is saturated or unsaturated, straight or branched hydrocarbon having from 1 to 10 carbon atoms, or $(R^5O)_nH$ as defined above or phenalkyl having an alkyl group of from 0 to 3 carbon atoms.

Metal ion free developers according to the invention comprising one or more surfactants of formula II above, have been found more selective in developing exposed areas of photoresist, and to have little or no attack on the unexposed photoresist. A metal ion free developer, made according to the invention, markedly reduces the required exposure time to create the required image by from forty to fifty percent, and thus increases wafer throughput.

By comparison, using known developers, a reduction of exposure time by forty to fifty percent cannot be achieved even by using a bath of increased concentration, because of attack on the unexposed photoresist. Thus, known developers show much less selectivity between exposed and unexposed areas.

Among the preferred surfactants are those comprising ethoxylated quaternary ammonium compounds having the general formula:

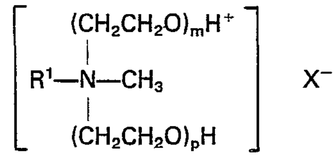

(IV)

wherein

m and p are each 1 or 2 and $R^1$ is alkyl of from 8 to 18 carbon atoms in approximately the following proportions:

TABLE I

| $R^1$ Carbon chain length | % |
|---|---|
| $C_8$ | 5 |
| $C_{10}$ | 6 |
| $C_{12}$ | 51 |
| $C_{14}$ | 19 |
| $C_{16}$ | 9 |
| $C_{18}$ | 5 |

Most preferably such surfactants comprise ethoxylated quaternary ammonium compounds wherein m and p are each 1, that is, methylbis-(2-hydroxyethyl)cocoammonium chloride. Such surfactants can be derived from coconut oil, and one such is commercially available under the trademark "Ethoquad C/12" (Armak Co., Pasadena, Texas, sold as a 75% active solution).

Also preferred are the compounds of the formula I wherein $R^2$, $R^3$ and $R^4$ are alkyl of 1 to 3 carbon atoms, most preferably methyl, and $R^1$ is as defined in formula IV. Most preferred of such surfactants is trimethylcocoammonium chloride, which surfactant can be derived from coconut oil and is commercially available under the trademark "Arquad C-50" (Armak Company, Pasadena, Texas, sold as a 50% active solution).

Another preferred surfactant comprises a mixture of two compounds, one conforming to formula IV where $R^1$ has 12 carbon atoms and m and p total 15 and the second wherein $R^1$ is 90% $C_{18}$ and 10% $C_{16}$. This surfactant is available under the trademark "Ethoquad 18/25" (Armak Company, Pasadena, Texas, sold as a 90% active solution).

The amount of such surfactant employed in the developer composition of the invention will depend in part upon the quaternary ammonium compound(s) chosen and the particular application for which it is used. Thus, for example, if the surfactant comprises Ethoquad C/12, described above, and the alkali is tetramethylammonium hydroxide ("TMAH"), the total amount used is from 0.02 to 45 grams ofa ctive C/12 per kgm TMAH, and more preferably, from about 0.1 to 7.5 grams of active C/12 per kgm of TMAH. In one most preferred embodiment, from about 0.2 to 10 grams of active Ethoquad C/12 is used in conjunction with from about 1 to 4 grams of active Ethoquad 18/25 per kgm TMAH.

The quaternary ammonium compounds, one or more of which compriss the surfactant of the developer compositions, can be readily prepared according to methods well known to those skilled of the art. Alternately, many suitable compounds or, preferably, mixtures of compounds, are readily commercially available.

While not intending to be bound by theory, it is currently believed that the newly discovered efficacy of the compounds of formula I results from their ability to reduce the surface tension of the developer bath at the interface with the photoresist. Thus, there is improved wetting of the exposed photoresist with the developer continuously through the development of the photomechanical image. In this way, the alkali of the developer has better contact and thus more effective action on the acids of the exposed portions of the resist.

It is theorized that such ability to reduce surface tension stems in large part from the affinity of the hydrophobic $R^1$ moiety, for the polymeric resin of the photoresist. In this regard, it is further theorized that surfactants comprising a mixture of such compounds, wherein the length of the $R^1$ carbon claim varies, are especially efficatious because the resin system typically also comprises carbon chains of varied length. For example, in the case of a novolak resin there are different novolak resin structures. Thus, different $R^1$ chain lengths provide the greatest affinity and hence the greatest wetting action for each of those different structures. Thus, a synergistic effect is achieved through the combined action of the different length $R^1$ carbon chains.

In addition to the alkali and surfactant described above, the developer composition of the invention may further comprise one or more suitable polyhydric compounds. Suitable polyhydric compounds for use in aqueous alkaline developers are known to the skilled of the art and include glycerol, ethylene glycol and polyglycols and glycol ethers. Glycerol is preferred. While not wishing to be bound by theory, it is believed that glycerol, or other suitable polyhydric compounds, act as a wetting agent and solvent and improves the quality of the photomechanical image. Amounts up to about 35 grams per liter of glycerol have been found to be particularly suitable. Preferably, an amount of about 25 to 30 grams per liter is used, most preferably about 27 grams per liter.

The present invention provides a novel metal ion-free, high speed developer suitable for development of positive type photoresists. It is believed to be suitable for etching unsensitized polyamide films in two-layer processing. It is particularly effective for development of positive photoresist containing

diazo-type sensitizer, such as 1-oxo-2-diazi-naphthalene-5-sulfonate ester in a novolak resin system. Such positive-type photoresists include, for example, the AZ 1300 series and AZ 1400 series photoresists marketed by Shipley Company Inc. of Newton, Massachusetts. The developer of the invention is also highly effective for development of such photoresists containing different sensitizers, for example, 1-oxo-2-diazonaphthalene-4-sulfonate ester or other photoactive materials known to the skilled of the art.

The developer dissolves those portions of such photoresists which have been exposed to actinic radiation, with improved selectivity. That is, even when the amount of exposure energy is reduced, the developer composition of the invention will dissolve the exposed portion(s) with less attack on the unexposed portion(s) than known developers. Thus, better image resolution and quality is provided while the rate of production is increased due to the reduced exposure time.

The developer composition of the invention can comprise components in addition to those described above. Such other components include, for example, dyes, additional wetting agents, buffers, and others known to the skilled in the art. It is a significant advantage of the embodiments of the present invention that work pieces, such as integrated circuit devices, are not contaminated by metal ions from the developer composition. In this regard, the metal ion-free developer compositions are especially advantageous for use with automated, in-line developing methods in which there is no rinse of the reverse side of the device after development of the photomechanical image. Often in such applications, a portion of the developer solution is not rinsed away and ion contamination of the device results. However, if metal ion-free developer according to the present invention is employed, such unrinsed developer will not cause metal ion contamination of the work piece.

Accordingly, not only is there increased speed of production and improved quality, there is also the elimination of metal ion contamination and consequent device failure.

The following examples will illustrate the invention and is not intended to be taken as a limitation thereof.

Example I

A photoresist developer composition according to the invention was prepared as follows: to 14706 ml of deionized water was added 1000 g of tetramethylammonium hydroxide. Next was added 511 of glycerol. Next was added 7.125 gm of active Ethoquad C/12 (Armak Co.). Finally, an additional 10,000 ml of deionized water was added. The above was mixed for half an hour and was ready for dilution to suit the desired processing conditions.

Example II

The speed and selectivity of the instant developer composition was compared to that of known developers. Silicon wafers, each of 7.62 cm (3 inches) diameter, were coated with AZ 1470 photoresist (Shipley Company Inc., Newton, Massachusetts) at a thickness of 1.4 µm. The coated wafers were exposed with 45 millijoules $cm^{-2}$ energy from an actinic radiation source through a graduated density stepfilter. The wafers, 3 each, were immersion developed for 20 seconds in 1 of 4 developer solutions and immersion rinsed in deionized water for 60 seconds and then blown dry with $N_2$. The first 3 solutions were separate batches of developer solution made according to the method of Example I. The fourth bath was (MF 312) Developer (Shipley Company, Newton, MA.) prepared by mixing 3 parts developer and 2 parts deionized water, and used according to directions. All solutions were used at 22.5°C. Following development the resist layers were again measured for thickness to determine selectivity, that is, the amount of loss of unexposed resist, and visually examined to determine the percent transmission needed for complete development. The results are tabulated below:

TABLE I

| Developer solution | Energy transmitted for step clearance identical | Resist thickness loss (nm) |
|---|---|---|
| Batch 1 | 22.5 | 50 |
| " | " | 50 |
| " | " | 60 |
| | | Avg. 53.3 nm |
| Batch 2 | 22.5 | 50 |
| " | " | 45 |
| " | " | 45 |
| | | Avg. 46.7 nm |
| Batch 3 | 22.5 | 50 |
| " | " | 40 |
| " | " | 40 |
| | | Avg. 43.3 nm |
| MF312 | 48.0 | 100 |
| " | " | 110 |
| " | " | 95 |
| | | Avg. 101.7 nm |

The results for the three batches of the metal ion-free developer of the invention are consistent within experimental error. The test results show that the metal ion-free developer is approximately 2.1 times faster, that is, requires 2.1 times less exposure energy, than the MF312 developer used as a control.

Moreover, regarding selectivity, visual composition of the wafers under a microscope revealed that each batch of the metal ion-free developer of the invention had virtually no effect on the photoresist receiving less than approximately 18 to 20% transmission. Thus, unless having received at least about 22.5% transmission and being developed completely, the photoresist was unattacked by the developer. By comparison, photoresist developed with MF/312 which received less than the 48% transmission needed for complete development, over a broad range down to 1.0% was attacked by the developer to a significant extent.

Example III

Metal ion-free developer according to Example I (herein "MIF") was diluted to 5 parts developer and 1 part D.I. water and compared to a known developer MF312 (a standard Shipley product) at a dilution of three parts developer to two parts deionized water over a temperature range from 14°C to 26°C. Selectivity was measured as the loss of unexposed resist.

Twenty-eight (28) wafers, each 3 inches diameter, were spin coated with 1.5 µm AZ 1470 photoresist (Shipley Company, Newton, MA) at 2500 RMP. The coated wafers were exposed to actinic radiation of 45 millijoules $cm^{-2}$ through a step mask. Following exposure the wafers were immersion developed for 20 seconds and then immersions rinsed in deionized water for 60 seconds. The results are tabulated below:

TABLE III

| Developer solutions | Temperature (°C) | Thickness loss (μm) | % Energy transmitted to clear two identical step |
|---|---|---|---|
| MIF | 14 | 0.02 | 25 |
| MIF | 14 | 0.02 | 25 |
| MF312 | 14 | 0.05 | 50 |
| 312 | 14 | 0.05 | 50 |
| MIF | 16 | 0.02 | 25 |
| MIF | 16 | 0.02 | 25 |
| 312 | 16 | 0.05 | 50 |
| 312 | 16 | 0.05 | 50 |
| MIF | 18 | 0.05 | 25 |
| MIF | 18 | 0.05 | 25 |
| 312 | 18 | 0.08 | 50 |
| 312 | 18 | 0.08 | 50 |
| MIF | 20 | 0.05 | 22 |
| MIF | 20 | 0.05 | 22 |
| 312 | 20 | 0.10 | 50 |
| 312 | 20 | 0.10 | 50 |
| MIF | 22 | 0.05 | 20 |
| MIF | 22 | 0.05 | 20 |
| 312 | 22 | 0.10 | 50 |
| 312 | 22 | 0.10 | 50 |
| MIF | 24 | 0.05 | 20 |
| MIF | 24 | 0.05 | 20 |
| 312 | 24 | 0.10 | 50 |
| 312 | 24 | 0.10 | 50 |
| MIF | 26 | 0.05 | 20 |
| MIF | 26 | 0.05 | 20 |
| 312 | 26 | 0.10 | 45 |
| 312 | 26 | 0.10 | 45 |

MIF dilution used was 5 parts developer Normality 0.45N
1 part DI water

MF312 dilution at 3 parts developer Normality 0.31N
2 parts DI water

The results show that the metal ion-free developer of the solution is more than twice as fast, that is, requires less than one half the exposure energy as the MF312 Developer. It is also shown that the metal ion-free developer is more than twice as selective, causing less than one half the loss of unexposed resist. It was also observed that the metal ion-free developer provided far superior image resolution.

**Claims**

1. An aqueous metal ion-free developer composition comprising a metal ion-free alkali and metal ion-free surfactant comprising one or more quaternary ammonium compounds having the general formula:

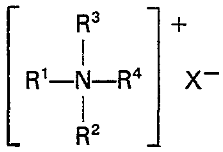

wherein

$R^1$ comprises a saturated or unsaturated, straight or branched hydrocarbon chain having from 6 to 20 carbons, and from zero to 3 oxygens, provided that each oxygen can be separated from others by at least one carbon, and which is alkoxy-substituted or unsubstituted;

$R^2$ and $R^3$ are the same or different and each comprises alkyl of from 1 to 3 carbons; or $(R^5O)_nH$ wherein $R^5$ is alkylene of 1 to 3 carbons and n is an integer from 1 to 20; or $R^2$ and $R^3$ together comprise a cycloaliphatic hydrocarbon of from 2 to 8 carbons with from zero to 2 heteroatom selected from O, N, and S, provided that each heteroatom be separated from another and from the quaternary nitrogen by at least one carbon; or $R^2$ and $R^3$ together comprise a cycloaromatic hydrocarbon of from 2 to 8 carbons with from zero to two nitrogen heteroatoms, provided that each nitrogen atom be separated from another and from the quaternary nitrogen by at least one carbon;

$R^4$ comprises a saturated or unsaturated, straight or branched hydrocarbon having from 1 to 10 carbon atoms, $(R^5O)_nH$ as defined above, phenalkyl, wherein the alkyl moiety has from 0 to 3 carbons, or

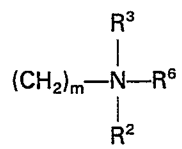

wherein m is from 1 to 4, $R^2$ and $R^3$ are as defined above, and $R^6$ is saturated or unsaturated, straight or branched hydrocarbon having from 1 to 10 carbon atoms or $(R^5O)_nH$ as defined above, or phenalkyl having an alkyl group of from 0 to 3 carbon atoms; and

X comprises halogen, hydroxy, or silicate, or the corresponding amino oxide of said quaternary ammonium compounds.

2. The developer composition of claim 1 wherein

$R^1$ comprises a saturated or unsaturated straight or branched hydrocarbon having from 6 to 20 carbon atoms;

$R^2$ and $R^3$ are the same or different and each comprises alkyl of from 1 to 3 carbons or $(R^5O)_nH$ wherein $R^5$ is alkylene of 1 to 3 carbons and n is an integer from 1 to 20;

$R^4$ comprises a saturated or unsaturated, straight or branched hydrophobic hydrocarbon having from 1 to 10 carbon atoms; $(R^5O)_nH$ as defined above; or phenalkyl, wherein the alkyl moiety has from 0 to 3 carbons; and

X comprises halogen, oxide, hydroxide or silicate.

3. The developer composition of claim 1 where $R^4$ conforms to the formula

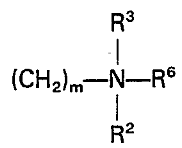

wherein $R^2$ and $R^3$ are as above defined, m is an integer of from 1 to 4 and $R^6$ is a saturated or unsaturated, straight or branched chain hydrocarbon having from 1 to 10 carbon atoms.

4. The developer composition of claim 1 wherein the alkali comprises tetraalkylammonium hydroxide, wherein each alkyl substituent is the same or different and has from 1 to 3 carbons.

5. Developer of composition of claim 4 wherein the alkali comprises tetramethylammonium hydroxide.

6. The developer composition of claim 4 wherein the alkali comprises tetramethylammonium silicate.

7. The developer composition of claim 1 wherein said surfactant comprises ethoxylated quaternary ammonium salts having the general formula:

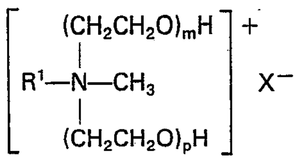

II

wherein $R^1$ is alkyl of from 8 to 18 carbons in approximately the following proportions:

| $R^1$ Carbon chain length | % |
|---|---|
| $C_8$ | 5 |
| $C_{10}$ | 6 |
| $C_{12}$ | 51 |
| $C_{14}$ | 19 |
| $C_{16}$ | 9 |
| $C_{18}$ | 5 |

m and p are integers from 1 to 20; and X is as defined in claim 1.

8. The developer composition of claim 7 wherein said surfactant comprises methylbis(2-hydroxyethyl)cocoammonium chloride.

9. The developer composition of claim 1 wherein said surfactant comprises quaternary ammonium salts of the formula

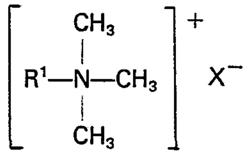

and $R^1$ is alkyl of from 8 to 18 carbons in approximately the following proportions:

| $R^1$ Carbon chain length | % |
|---|---|
| $C_8$ | 5 |
| $C_{10}$ | 6 |
| $C_{12}$ | 51 |
| $C_{14}$ | 19 |
| $C_{16}$ | 9 |
| $C_{18}$ | 5 |

10. The developer composition of claim 9 wherein said surfactant comprises trimethyl cocoammonium chloride.

11. The developer composition of any one of claims 1 through 4 further comprising a suitable polyhydric wetting agent.

12. The developer composition of claim 11 wherein said polyhydric wetting agent comprises glycerol.

13. A method of developing a photoresist comprising exposing said photoresist to actinic radiation and subsequently contacting it with an aqueous metal ion-free developer composition according to claim 1.

**Patentansprüche**

1. Wäßrige metallionenfreie Entwicklerzusammensetzung, enthaltend ein metallionenfreies Alkali und ein metallionenfreies oberflächenaktives Mittel, welches eine oder mehrere quaternäre Ammoniumverbindungen der allgemeinen Formel

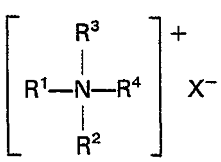

umfaßt, worin

$R^1$ eine gesättigte oder ungesättigte, geradkettige oder verzweigte Kohlenwasserstoffkette mit 6 bis 20 C-Atomen und 0 bis 3 Sauerstoffatomen, wobei jedes Sauerstoffatom durch mindestens ein Kohlenstoffatom von den anderen getrennt ist und wobei die Kohlenwasserstoffkette alkoxy-substituiert oder unsubstituiert ist;

$R^2$ und $R^3$, die gleich oder verschieden sind, jeweils Alkyl mit 1 bis 3 C-Atomen; oder $(R^5O)_nH$, worin $R^5$ Alkylen mit 1 bis 3 C-Atomen und n eine ganze Zahl von 1 bis 20 bedeuten; oder $R^2$ und $R^3$ zusammen einen cycloaliphatischen Kohlenwasserstoffrest mit 2 bis 8 C-Atomen und mit 0 bis 2 aus O, N und S ausgewählten Heteroatomen, wobei jedes der Heteroatome voneinader und vom quaternären Stickstoff durch mindestens ein Kohlenstoffatom getrennt ist; oder $R^2$ und $R^3$ zusammen einen cycloaromatischen Kohlenwasserstoffrest mit 2 bis 8 C-Atomen und mit 0 bis 2 Stickstoff-Heteroatomen, wobei jedes der Stickstoffatome voneinander und von dem quaternären Stickstoff durch mindestens ein Kohlenstoffatom getrennt ist;

$R^4$ einen gesättigten oder ungesättigten, geradkettigen oder verzweigten Kohlenwasserstoff mit 1 bis 10 C-Atomen, $(R^5O)_nH$, wie oben definiert, Phenalkyl, worin der Alkylrest 0 bis 3 C-Atome besitzt, oder

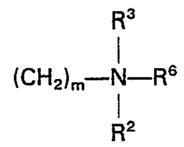

worin m eine Zahl von 1 bis 4 bedeutet, $R^2$ und $R^3$ die oben genannten Bedeutungen besitzen und $R^6$ ein gesättigter oder ungesättigter, geradkettiger oder verzweigter Kohlenwasserstoff mit 1 bis 10 C-Atomen oder $(R^5O)_nH$, wie oben definiert, oder Phenalkyl mit einer Alkylgruppe mit 0 bis 3 C-Atomen bedeutet; und

X Halogen, Hydroxy oder Silicat oder das entsprechende Aminooxid der quaternären Ammoniumverbindungen bedeuten.

2. Entwicklerzusammensetzung nach Anspruch 1, worin

$R^1$ einen gesättigten oder ungesättigten, geradkettigen oder verzweigten Kohlenwasserstoff mit 6 bis 20 C-Atomen,

$R^2$ und $R^3$, die gleich oder verschieden sind, jeweils Alkyl mit 1 bis 3 C-Atomen oder $(R^5O)_nH$, worin $R^5$ Alkylen mit 1 bis 3 C-Atomen und n eine ganze Zahl von 1 bis 20 bedeuten;

$R^4$ einen gesättigten oder ungesättigten, geradkettigen oder verzweigten hydrophoben Kohlenwasserstoff mit 1 bis 10 C-Atomen; $(R^5O)_nH$, wie oben definiert; oder Phenalkyl, worin die Alkylgruppe 0 bis 3 C-Atome aufweist; und

X Halogen, Oxid, Hydroxid oder Silicat bedeuten.

3. Entwicklerzusammensetzung nach Anspruch 1, dadurch gekennzeichnet, daß $R^4$ der Formel

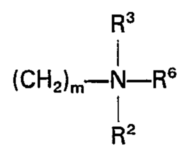

entspricht, worin $R^2$ und $R^3$ die oben genannten Bedeutungen besitzen, m eine ganze Zahl von 1 bis 4 und $R^6$ ein gesättigter oder ungesättigter, geradkettiger oder verzweigter Kohlenwasserstoff mit 1 bis 10 C-Atomen bedeuten.

4. Entwicklerzusammensetzung nach Anspruch 1, dadurch gekennzeichnet, daß das Alkali Tetraalkylammoniumhydroxid ist, wobei jeder Alkylrest, der gleich oder verschieden sein kann, 1 bis 3 C-Atome aufweist.

5. Entwicklerzusammensetzung nach Anspruch 4, dadurch gekennzeichnet, daß das Alkali Tetramethylammoniumhydroxid ist.

6. Entwicklerzusammensetzung nach Anspruch 4, dadurch gekennzeichnet, daß das Alkali Tetramethylammoniumsilicat ist.

7. Entwicklerzusammensetzung nach Anspruch 1, dadurch gekennzeichnet, daß das oberflächenaktive Mittel äthoxylierte quaternäre Ammoniumsalze der allgemeinen Formel

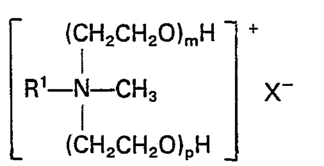

II

umfaßt, worin $R^1$ Alkyl mit 8 bis 18 C-Atomen in etwa folgenden Verhältnissen:

| Länge der Kohlenstoffkette $R^1$ | % |
|---|---|
| $C_8$ | 5 |
| $C_{10}$ | 6 |
| $C_{12}$ | 51 |
| $C_{14}$ | 19 |
| $C_{16}$ | 9 |
| $C_{18}$ | 5 |

m und p ganze Zahlen von 1 bis 20 bedeuten und X die im Anspruch 1 angegebenen Bedeutungen besitzt.

8. Entwicklerzusammensetzung nach Anspruch 7, dadurch gekennzeichnet, daß das oberflächenaktive Mittel Methyl-bis(2-hydroxyäthyl)-cocoammoniumchloride ist.

9. Entwicklerzusammensetzung nach Anspruch 1, dadurch gekennzeichnet, daß das oberflächenaktive Mittel quaternäre Ammoniumsalze der Formel

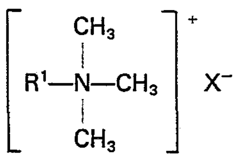

umfaßt und $R^1$ Alkyl mit 8 bis 18 C-Atomen in etwa folgenden Verhältnissen:

| Länge der Kohlenstoffkette $R^1$ | % |
|---|---|
| $C_8$ | 5 |
| $C_{10}$ | 6 |
| $C_{12}$ | 51 |
| $C_{14}$ | 19 |
| $C_{16}$ | 9 |
| $C_{18}$ | 5 |

bedeutet.

10. Entwicklerzusammensetzung nach Anspruch 9, dadurch gekennzeichnet, daß das oberflächenaktive Mittel Trimethylcocoammoniumchlorid ist.

11. Entwicklerzusammensetzung nach einem der Ansprüche 1 bis 4, dadurch gekennzeichnet, daß sie zusätzlich ein geeignetes polyhydroxyliertes Netzmittel enthält.

12. Entwicklerzusammensetzung nach Anspruch 11, dadurch gekennzeichnet, daß das polyhydroxylierte Netzmittel Glycerin ist.

13. Verfahren zum Entwickeln eines Photoresists, bei dem der Photoresist aktinischer Strahlung ausgesetzt und anschließend mit einer wäßrigen, metallionenfreien Entwicklerzusammensetzung nach Anspruch 1 behandelt wird.

**Revendications**

1. Composition aqueuse d'agent de développement dépourvue d'ions métalliques comprenant une base dépourvue d'ions métalliques et un agent tensio-actif dépourvu d'ions métalliques comprenant un ou plusieurs composés d'ammonium quaternaire de formule générale:

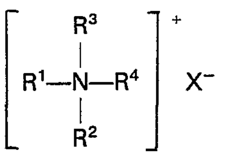 (I)

où

$R^1$ comprend une chaîne hydrocarbonée saturée, non saturée, droite ou ramifiée, ayant 6 à 20 carbones, et ayant de 0 à 3 atomes d'oxygène, à condition que chaque atome d'oxygène puisse être séparé des autres par au moins un atome de carbone, et qui est alcoxy-substituée ou non substituée;

$R^2$ et $R^3$ sont semblables ou différents et comprennent chacun un alcoyle ayant 1 à 3 carbones ou $(R^5O)_nH$ où $R^5$ est un alcoylène ayant 1 à 3 carbones et n est un nombre entier allant de 1 à 20; ou $R^2$ et $R^3$ ensemble comprennent un hydrocarbure cycloaliphatique ayant 2 à 8 carbones avec de 0 à 2 hétéroatomes choisis entre O, N et S, à condition que chaque hétéroatome soit séparé des autres et de l'azote quaternaire par au moins un atome de carbone; ou $R^2$ et $R^3$ ensemble comprennent un hydrocarbure cycloaromatique ayant 2 à 8 carbones avec de 0 à 2 hétéroatomes d'azote, à condition que chaque atome d'azote soit séparé des autres et de l'atome d'azote quaternaire par au moins un atome de carbone;

$R^4$ comprend un hydrocarbure saturé ou non saturé, à chaîne droite ou ramifiée ayant de 1 à 10 atomes de carbone, $(R^5O)_nH$ tel que défini ci-dessus, un phénalcoyle où la fraction alcoyle a de 0 à 3 atomes de carbone, ou

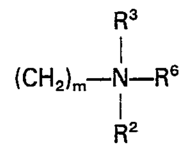

où m a une valeur comprise entre 1 et 4

$R^2$ et $R^3$ sont tels que définis ci-dessus, et $R^6$ est un hydrocarbure saturé ou non saturé, à chaîne droite ou ramifiée ayant de 1 à 10 atomes de carbone ou $(R^5O)_nH$ tel que défini ci-dessus, ou un phénol-alcoyle ayant un groupe alcoyle ayant de 0 à 3 atomes de carbone; et

X comprend un halogène, un hydroxyde, ou un silicate, ou l'amino-oxyde correspondant desdits composés d'ammonium quaternaires.

2. Composition pour développement de la revendication 1 où

$R^1$ comprend un hydrocarbure saturé ou non saturé à chaîne droite ou ramifiée ayant de 6 à 20 atomes de carbone;

$R^2$ et $R^3$ sont semblables ou différentes et comprennent chacun un alcoyle avec 1 à 3 carbones ou $(R^5O)_nH$ où

$R^5$ est un alcoylène avec 1 à 3 carbones et n est un nombre entier allant de 1 à 20;

$R^4$ comprend un hydrocarbure hydrophobe saturé ou non saturé, à chaîne droite ou ramifiée ayant de 1 à 10 atomes de carbone; $(R^5O)_nH$ tel que défini ci-dessus; ou un phénalcoyle, où la fraction alcoyle a de 0 à 3 atomes de carbone; et

X comprend un halogène, un oxyde, un hydroxyde ou un silicate.

3. Composition pour développement objet de la revendication 1 où $R^4$ répond à la formule

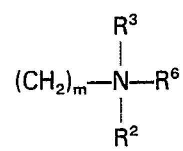

où $R^2$ et $R^3$ sont tels que définis ci-dessus, m est un nombre entier allant de 1 à 4 et $R^6$ est un hydrocarbure saturé ou non saturé à chaîne droite ou ramifiée ayant de 1 à 10 atomes de carbone.

4. Composition pour développement objet de la revendication 1 où la base comprend un hydroxyde de tétraalcoylammonium, où chaque substituant alcoyle est semblable ou différent et a de 1 à 3 atomes de carbone.

5. Agent de développement ayant la composition objet de la revendication 4 où la base comprend l'hydroxyde de tétraméthylammonium.

6. Composition pour développement objet de la revendication 4 où la base comprend le silicate de tétraméthylammonium.

7. Composition pour développement objet de la revendication 1 où ledit agent tensio-actif comprend des sels d'ammonium quaternaire éthoxylés de formule générale

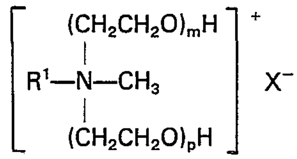 II

où $R^1$ est un alcoyle ayant de 8 à 18 carbones, approximativement dans les proportions suivantes:

| Longueur de chaîne carbonée $R^1$ | % |
|---|---|
| $C_8$ | 5 |
| $C_{10}$ | 6 |
| $C_{12}$ | 51 |
| $C_{14}$ | 19 |
| $C_{16}$ | 9 |
| $C_{18}$ | 5 |

m et p sont des nombres entiers allant de 1 à 20; et

X est tel que défini dans la revendication 1.

8. Composition pour développement objet de la revendication 7 où ledit agent tensio-actif comprend le chlorure de méthylbis-(2-hydroxyéthyl)-cocoammonium.

9. Composition pour développement objet de la revendication 1 où ledit agent tensio-actif comprend des sels d'ammonium quaternaires de formule

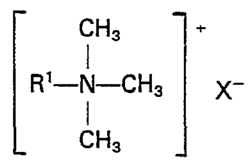

et $R^1$ est un alcoyle ayant 8 à 18 carbones, approximativement dans les proportions suivantes:

| Longueur de chaîne carbonée $R^1$ | % |
|---|---|
| $C_8$ | 5 |
| $C_{10}$ | 6 |
| $C_{12}$ | 51 |
| $C_{14}$ | 19 |
| $C_{16}$ | 9 |
| $C_{18}$ | 5 |

10. Composition pour développement objet de la revendication 9 où ledit agent tensio-actif comprend le chlorure de triméthyl-cocoammonium.

11. Composition pour développement objet d'une quelconque des revendications 1 à 4 comprenant en outre un agent mouillant polyhydrique approprié.

12. Composition pour développement objet de la revendication 11 où ledit agent mouillant polyhydrique comprend du glycérol.

13. Procédé pour développer une couche photorésistante dans lequel on expose ladite matière photorésistante à un rayonnement actinique puis on la met en contact avec une composition aqueuse de développement dépourvue d'ions métalliques selon la revendication 1.